(19) Europäisches Patentamt
European Patent Office
Office européen des brevets

(11) **EP 4 270 030 A1**

(12) **EUROPÄISCHE PATENTANMELDUNG**

(43) Veröffentlichungstag:
**01.11.2023  Patentblatt 2023/44**

(21) Anmeldenummer: **23169276.5**

(22) Anmeldetag: **21.04.2023**

(51) Internationale Patentklassifikation (IPC):
*G01R 31/389* (2019.01)    *B60L 58/16* (2019.01)
*H01M 10/48* (2006.01)    *H02J 9/06* (2006.01)

(52) Gemeinsame Patentklassifikation (CPC):
*G01R 31/389; B60L 58/16; G01R 31/386;*
*H01M 10/48; H02J 9/06*

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(30) Priorität: **29.04.2022   LU 501973**

(71) Anmelder: **PHOENIX CONTACT GmbH & Co. KG
32825 Blomberg (DE)**

(72) Erfinder:
• **MANTLER, Eugen
  32839 Steinheim (DE)**
• **KAYASTHA, Srishtik Prasad
  33100 Paderborn (DE)**

(74) Vertreter: **LifeTech IP
Spies & Behrndt Patentanwälte PartG mbB
Elsenheimerstraße 47a
80687 München (DE)**

(54) **VERFAHREN UND VORRICHTUNG ZUR ERMITTLUNG DER IMPEDANZ EINES WIEDERAUFLADBAREN ELEKTRISCHEN ENERGIESPEICHERS**

(57)    Gemäß einem ersten Aspekt wird ein Verfahren zur Ermittlung eines Innenwiderstandes eines wiederaufladbaren elektrischen Energiespeichers gezeigt. Das Verfahren umfasst ein Erfassen einer ersten Spannung des Energiespeichers während eine erste Stromstärke dem Energiespeicher entnommen wird. Weiter umfasst das Verfahren ein Erfassen einer zweiten Spannung des Energiespeichers während eine zweite Stromstärke dem Energiespeicher entnommen wird, die größer als die erste Stromstärke ist. Ergänzend umfasst das Verfahren, dass zwischen der Entnahme der ersten Stromstärke und der Entnahme der zweiten Stromstärke periodisch umgeschaltet wird. Optional umfasst das Verfahren ergänzend ein Ermitteln des Innenwiderstandes basierend auf den erfassten ersten und zweiten Spannungen, die bei den periodisch umgeschalteten ersten und zweiten Stromstärken erfasst sind.

Fig. 3

EP 4 270 030 A1

**Beschreibung**

Die Erfindung bezieht sich auf ein Verfahren und eine Vorrichtung zur Ermittlung der Impedanz eines wiederaufladbaren elektrischen Energiespeichers. Ohne darauf beschränkt zu sein, bezieht sie sich insbesondere auf eine kostengünstige Ermittlung der Impedanz von Batterien verschiedener Kapazitäten und verschiedener chemischer Wirkungsweisen ohne vorherige Anpassung einer diesbezüglichen Ermittlungsschaltung.

In verschiedenen unterbrechungsfreien Stromversorgungen werden oft Batterien verwendet, die den Betrieb der Stromversorgung auch bei temporären Ausfall einer externen Versorgungsspannung (zum Beispiel einer durch die allgemeinen Energieversorger bereitgestellte Versorgungsspannung, auch Primärversorgungsspannung genannt) sicherstellen. Insbesondere bei kurzzeitigen Unterbrechungen der Primärversorgungsspannung kann so die unterbrechungsfreie Versorgung der an die unterbrechungsfreie Stromversorgung angeschlossenen Verbraucher sichergestellt werden, um so Störungen bei den Verbrauchern zu vermeiden. Dazu ist es erforderlich, den ordnungsgemäßen Zustand der Batterie, die auch Pufferbatterie genannt werden kann, regelmäßig zu ermitteln und bei Bedarf den Anwender über eine entsprechende Fehlfunktion der Batterie zu unterrichten. Bisher bekannte Messverfahren der Batterieimpedanz nutzen Messungen mit Wechselspannung, fachsprachlich auch AC-Messung (für "Alternating Current") genannt. Diese liefern in aller Regel gute Ergebnisse. Alternativ sind auch Messungen mit Gleichspannungswerten bekannt, fachsprachlich auch DC-Messung (für "Direct Current") genannt. Diese sind einfacher zu realisieren und sind dadurch auch kostengünstiger aufgebaut.

Jedoch erfordern die Messungen mit Wechselspannung eine relativ komplexe und kostenintensive Messeinrichtung. Diese ist insbesondere bei einem Einsatz von hohen Stückzahlen in einem kostenbewussten Umfeld unwirtschaftlich. Die Messung mit Gleichspannungswerten werden bei höheren Batteriekapazitäten ungenau. Entsprechend sind sie für den Einsatz eines breiten Spektrums von Batteriekapazitäten nicht gut geeignet. Somit ist die Messung des Batteriezustandes entweder kostenintensiv oder es ist eine Mehrzahl von verschiedenen Messeinrichtungen in Abhängigkeit der Batteriekapazität notwendig.

Zum Messen einer Batteriekapazität schlägt die Druckschrift BU-902: "How to Measure Internal Resistance", Battery University, ein Messverfahren mit zwei verschiedenen Gleichstromstromstärken vor, die nacheinander der Batterie entnommen werden. Daraus kann der ohmsche Widerstand der Batterie ermittelt werden.

Der Erfindung liegt daher die Aufgabe zu Grunde, eine Technik anzugeben, mit der der Innenwiderstand von Batterien mit verschiedenen Kapazitäten kostengünstig und ohne Anpassung der Messeinrichtung an die Batteriekapazität ermittelt werden kann.

Die Aufgabe wird mit den Merkmalen der unabhängigen Ansprüche gelöst. Zweckmäßige Ausgestaltungen und vorteilhafte Weiterbildungen der Erfindung sind in den abhängigen Ansprüchen angegeben.

Ausführungsbeispiele der Erfindung, die wahlweise miteinander kombinierbar sind, sind im Folgenden unter teilweiser Bezugnahme auf die Figuren offenbart.

Ein erster Aspekt betrifft ein Verfahren zur Ermittlung eines Innenwiderstandes eines wiederaufladbaren elektrischen Energiespeichers. Das Verfahren umfasst ein Erfassen einer ersten Spannung des Energiespeichers während eine erste Stromstärke dem Energiespeicher entnommen wird. Weiter umfasst das Verfahren ein Erfassen einer zweiten Spannung des Energiespeichers während eine zweite Stromstärke dem Energiespeicher entnommen wird, die größer als die erste Stromstärke ist. Ergänzend umfasst das Verfahren, dass zwischen der Entnahme der ersten Stromstärke und der Entnahme der zweiten Stromstärke periodisch umgeschaltet wird. Optional umfasst das Verfahren ergänzend ein Ermitteln des Innenwiderstandes basierend auf den erfassten ersten und zweiten Spannungen, die bei den periodisch umgeschalteten ersten und zweiten Stromstärken erfasst sind.

Vorteilhaft kann so mit einem einfachen und somit kostengünstig zu realisierenden Messverfahren der ohmsche Innenwiderstand des wiederaufladbaren elektrischen Energiespeichers bei verschiedenen Kapazitäten mit guter Genauigkeit ermittelt werden.

Es kann dabei für Batterien mit einer geringen und mittleren Kapazität, insbesondere bei Kapazitäten zwischen 1 Ah und 100 Ah, der Innenwiderstand mit ausreichender Genauigkeit gemessen werden. Vorteilhaft müssen dafür lediglich die Spannungen während zwei verschiedenen Stromstärken abwechselnd gemessen werden.

Optional kann in Ergänzung der ersten Stromstärke und der zweiten Stromstärke das Verfahren dazu ausgebildet sein noch eine dritte Stromstärke und ggf. optional noch eine vierte Stromstärke und ggf. optional noch eine fünfte Stromstärke der Batterie zu entnehmen. Alle jeweils gewählten Stromstärken werden periodisch umgeschaltet. Vorteilhaft kann so auch der Innenwiderstand von Batterien mit größerer Kapazität ausreichend genau ermittelt werden. Beispielsweise kann die Batteriekapazität dabei bis zu 100 Ah oder auch darüber hinaus bis zu über 200 Ah betragen.

Der Innenwiderstand kann basierend auf einer Teilmenge der erfassten ersten und zweiten Spannungen ermittelt werden. Dabei kann vorteilhaft die Beobachtung ausgenutzt werden, dass zu Beginn einer periodischen Stromentnahme die Spannung an den Batteriepolen stark einbricht und sich in den ersten Perioden auch deutlich verändert. Dabei nimmt bei jeder weiteren Periode die Spannung zu bei gleichzeitiger kleiner werdender Spannungsdifferenz zur vorhergehenden Periode. Nach einer Anzahl von Messperioden mit den verschiedenen Stromstärken erreicht die Spannung einen relativ konstanten Wert. Entsprechend kann vorteilhaft unter Ausblendung der starken Spannungseinbrüche die relativ konstante Spannung zur Ermittlung des Innenwiderstandes berücksichtigt werden, um konstante Spannungswerte bei der jeweiligen Stromentnahme zu erreichen.

Beispielsweise können aus 40 Messperioden, wobei jede Messperiode die Entnahme der ersten Stromstärke und anschließend die Entnahme der zweiten Stromstärke umfassen kann, die letzten 10 Messperioden der Teilmenge zum Ende eines Messvorgangs entsprechen. Alternativ können die ersten 30 Messperioden der Teilmenge zum Anfang eines Messvorgangs entsprechen. Es kann auch vorgesehen sein, eine Kombination beider Teilmengen zu benutzen. Dadurch kann vorteilhaft ein mittlerer Bereich der jeweiligen gemessenen Spannungen ausgewählt werden.

Die erste Spannung und die zweite Spannung variieren auch während der jeweiligen Stromentnahme. Optional kann durch die Mittelung der einzelnen gemessenen Spannungsverläufe bei der jeweiligen Stromentnahme die Messgenauigkeit weiter verbessert werden. Beispielsweise kann die Mittelung gemäß eines RMS-Verfahrens (für fachsprachlich "Root mean square", auf Deutsch Quadratisches Mittel oder Effektivwert genannt) erfolgen.

Die Teilmenge der erfassten ersten und zweiten Spannungen kann eine zum zeitlichen Ende einer konstanten (ersten oder zweiten) Stromstärke hin erfasste Teilmenge der ersten und zweiten Spannungen umfassen. Weiter kann zusätzlich oder alternativ eine am Anfang eines Messvorgangs erfasste Teilmenge der ersten und zweiten Spannungen ausgeschlossen werden. Für eventuelle dritte und weitere Spannungen, die auf entsprechenden dritten und weiteren Stromentnahmen basieren, gilt das entsprechend.

Optional kann die erfasste Teilmenge der ersten und zweiten Spannungen eine vorgegebene Anzahl von Spannungen sein. Beispielsweise können die letzten 25% der erfassten Spannungen der Teilmenge zum Ende eines Messvorgangs entsprechen. Es können auch die letzten 20% oder 30% der erfassten Spannungen der Teilmenge zum Ende eines Messvorgangs entsprechen. Weiter optional kann das Verhältnis der erfassten und ausgeschlossenen ersten und zweiten Spannungen eingestellt werden. Dies kann automatisch erfolgen auf Basis erkannter Eigenschaften des wiederaufladbaren elektrischen Energiespeichers, beispielsweise der Nennspannung oder der Leerlaufspannung des elektrischen Energiespeichers. Es kann alternativ oder ergänzend auch durch Benutzereingaben bestimmt werden.

Vorteilhaft kann so die Berücksichtigung der während des Messvorgangs erfassten ersten und zweiten Spannungen flexibel gewählt werden, um beispielsweise Besonderheiten bestimmter wiederaufladbarer elektrischer Energiespeicher, die zum Beispiel als Batterien ausgeführt sein können, zu berücksichtigen.

Während des ausgeschlossenen Anfangs des Messvorgangs kann eine Änderungsrate der ersten Spannung und/oder der zweiten Spannung größer als ein erster Schwellwert sein. Ergänzend oder alternativ kann während der zum Ende des Messvorgangs hin erfassten Teilmenge eine Änderungsrate der ersten Spannung und/oder der zweiten Spannung kleiner als ein zweiter Schwellwert sein. Dabei kann die Änderungsrate sich aufeinanderfolgende Werte der ersten Spannung und/oder der zweiten Spannung beziehen. Alternativ können auch nicht aufeinanderfolgende Werte der ersten Spannung und/oder der zweiten Spannung für den Schwellwert berücksichtigt werden. Optional kann der zweite Schwellwert kleiner oder gleich dem ersten Schwellwert sein.

Vorteilhaft können so erste Spannungen und/oder zweiten Spannungen mit ähnlichen Werten für eine Auswertung berücksichtigt werden. Somit kann die Auswertequalität verbessert werden. Weiter vorteilhaft ist es, verschiedene Änderungsraten berücksichtigen zu können. So kann auf die Eigenschaften des jeweils vorliegenden wiederaufladbaren elektrischen Energiespeichers flexibel reagiert werden.

Eine weitere Verbesserung kann durch die Wählbarkeit des ersten Schwellwerts und des zweiten Schwellwerts erzielt werden, um Besonderheiten bestimmter wiederaufladbarer elektrischer Energiespeicher, die zum Beispiel als Batterien ausgeführt sein können, zu berücksichtigen. Die Bestimmung des ersten Schwellwerts und/oder des zweiten Schwellwerts kann automatisch erfolgen zum Beispiel auf Basis erkannter Eigenschaften des wiederaufladbaren elektrischen Energiespeichers, beispielsweise der Nennspannung oder der Leerlaufspannung des elektrischen Energiespeichers. Es kann alternativ oder ergänzend auch durch Benutzereingabe bestimmt werden.

Zur Ermittlung des Innenwiderstandes je Dauer der ersten und zweiten Stromstärke kann die erste beziehungsweise zweite Spannung nur in einem Abschnitt der Dauer erfasst werden. Optional kann die Erfassung zum Ende oder in einem letzten Abschnitt der Dauer der ersten beziehungsweise zweiten Stromstärke erfolgen. Beispielsweise kann der letzte Abschnitt der Dauer ein Viertel je Dauer, d.h. 25%, der ersten und zweiten Stromstärke beziehungsweise der ersten beziehungsweise zweiten Spannung umfassen. Er kann aber auch 20% oder 30% je Dauer umfassen. Weiter optional kann die Erfassung zum Anfang oder in einem ersten Abschnitt der Dauer der ersten beziehungsweise zweiten Stromstärke erfolgen. Die Bestimmung der Dauer und deren Positionierung im letzten oder ersten Abschnitt der Dauer kann dabei automatisch erfolgen, zum Beispiel auf Basis erkannter Eigenschaften des wiederaufladbaren elektrischen Energiespeichers. Sie kann optional aus dem Spannungsverlauf der ersten oder zweiten Spannung während der Dauer abgeleitet werden. Es kann alternativ oder ergänzend auch durch Benutzereingabe bestimmt werden. Weiter optional kann zwischen der Erfassung des ersten Abschnitts und der Erfassung des letzten Abschnitts der Spannung umgeschaltet werden. Das Umschalten kann auf einem Schwellwert basieren. In Ausführungsformen kann der Schwellwert auf der Änderungsrate der ersten Spannung und/oder der zweiten Spannung basieren.

Es ist zu beobachten, dass während der Dauer der ersten und zweiten Stromstärke die erste beziehungsweise zweite Spannung sich verändern kann. Entsprechend kann durch die nur teilweise Berücksichtigung der Spannungen (beispielsweise der Spannungsverläufe) die zur Weiterverarbeitung bestimmten Werte vorteilhaft eingegrenzt werden, zum Beispiel auf die jeweils höchsten Werte der ersten beziehungsweise zweiten Spannung. Diese können auch im Anfang oder in einem ersten Abschnitt der Dauer liegen. Alternativ oder ergänzend können aus einer Folge von Abtastwerten je Dauer der größte und der kleinste Wert ausgeschlossen werden, um Messfehler auszuschließen, oder es kann ein Median als Spannung aus der Folge von Abtastwerten je Dauer bestimmt werden.

Die erste und zweite Stromstärke können jeweils konstant sein. Sie können einen als Rechteck ausgeprägten Verlauf der Stromstärke aufweisen. Vorteilhaft kann der Verlauf durch Schalter realisiert werden, die zum Beispiel als Relais oder Transistoren ausgeführt sein können und somit eine einfache und kostengünstige Realisierung erlauben.

Die Dauer der Entnahme der ersten und zweiten Stromstärke kann gleich sein. Ergänzend oder alternativ kann ein Tastgrad der ersten und zweiten Stromstärke (d.h. ein zeitlicher Anteil der jeweiligen Dauer an der Periodendauer des Umschaltens) von der Kapazität des wiederaufladbaren elektrischen Energiespeichers unabhängig sein. Weiter ergänzend oder alternativ kann eine Frequenz des periodischen Umschaltens von der Kapazität des wiederaufladbaren elektrischen Energiespeichers unabhängig sein. Alternativ kann der Tastgrad auch an die Kapazität des wiederaufladbaren elektrischen Energiespeichers angepasst werden. Vorteilhaft kann so für viele Batterietypen und Kapazitäten eine identische Einstellung beibehalten werden, was den Installations- und Wartungsaufwand reduziert. Weiter vorteilhaft kann für besondere Batterien und/oder Kapazitäten durch Anpassung des Tastgrades die Messgenauigkeit verbessert werden.

Der wiederaufladbare elektrische Energiespeicher kann elektrochemische Zellen umfassen. Dabei kann eine Nennspannung oder Leerlaufspannung des wiederaufladbaren elektrischen Energiespeichers im Bereich von 12 V bis 48 V liegen. Ergänzend oder alternativ kann eine Kapazität des wiederaufladbaren elektrischen Energiespeichers im Bereich von 1 Ah bis 100 Ah liegen. Alternativ können auch Kapazitäten über 200 Ah zum Einsatz kommen. Darüber hinaus kann bei Kapazitäten über 200 Ah optional in Ergänzung der ersten Stromstärke und der zweiten Stromstärke noch eine dritte Stromstärke und ggf. optional noch eine vierte Stromstärke und ggf. optional noch eine fünfte Stromstärke der Batterie entnommen werden, wie bereits oben vermerkt. Alle jeweils gewählten Stromstärken können periodisch (beispielsweise zyklisch) umgeschaltet werden. Vorteilhaft kann so die Messgenauigkeit bei großen Kapazitäten erhöht werden.

Der wiederaufladbare elektrische Energiespeicher kann zur Entnahme der ersten Stromstärke über einen ersten Widerstand entladen werden und zur Entnahme der zweiten Stromstärke über einen zweiten Widerstand. Alternativ kann die Entnahme der zweiten Stromstärke über eine Parallelschaltung des ersten Widerstands und eines zweiten Widerstands erfolgen. Dabei können Messwerte von Widerständen einer Messeinrichtung, auf denen die erste Stromstärke und die zweite Stromstärke basieren, in der Messeinrichtung hinterlegt sein. Die Messwerte können bei einer Kalibrierung der Messeinrichtung ermittelt werden. Optional können dabei die Messwerte der Widerstände der Messeinrichtung mindestens zehnfach größer als der Innenwiderstand des wiederaufladbaren elektrischen Energiespeichers sein. Weiter optional können die Widerstände für die erste Stromstärke 7,5 Ohm betragen und für die zweite Stromstärke 3,75 Ohm betragen. Vorteilhaft können so Entladeströme von 4,5 A bzw. 9,0 A erzielt werden, die zur Verbesserung der Messgenauigkeit beitragen. Bei diesen oder ähnlichen Stromstärken kann einerseits ein deutlicher Spannungsabfall der Klemmenspannung des Energiespeichers (als erste und zweite Spannung) gegenüber der Leerlaufspannung erfasst werden, und andererseits kann die joulesche Wärme mit einer ausreichenden Rate des Wärmetransports an den Messwiderständen entfernt werden ohne thermische Schäden.

In jedem Ausführungsbeispiel kann vorteilhaft durch die Hinterlegung der Messwerte von Widerständen in der Messeinrichtung auf die Messung der ersten Stromstärke und der zweiten Stromstärke verzichtet werden, was die Messeinrichtung vereinfacht.

Beim periodischen Umschalten zwischen der ersten und zweiten Stromstärke kann mittels eines Feldeffekttransistors zwischen dem ersten und dem zweiten Widerstand umgeschaltet werden. Alternativ kann mittels eines Feldeffekttransistors der zweite Widerstand parallel zum ersten Widerstand zugeschaltet werden. Optional kann dabei eine Frequenz des periodischen Umschaltens größer als oder gleich 100 Hz sein. So kann die Frequenz des periodischen Umschaltens zwischen 100 Hz und 5 kHz liegen. Vorteilhaft wird so die Genauigkeit der Messung weiter erhöht. Weiter vorteilhaft wird durch die Verwendung der Feldeffekttransistoren eine Beschränkung der Höhe der Umschaltfrequenz vermieden. Ergänzend wird Bauraum bei der Realisierung der Lösung gespart.

Die Messwerte können um den Widerstand von elektrisch leitenden Verbindungselementen zwischen dem elektrischen Energiespeicher und der Messeinrichtung korrigiert werden. Optional kann der Widerstand auf den ohmschen Anteil (realer Teil des Widerstandes) beschränkt sein. Weiter optional kann der Widerstand der elektrisch leitenden Verbindungselementen in der Messeinrichtung hinterlegt sein. Dies kann ein bei der Fertigung der Messeinrichtung gemessener Wert sein. Alternativ kann es auch ein konstanter Wert sein, der bei der Fertigung hinterlegt wird. Weiter alternativ kann der Wert auch ignoriert werden, wenn er unter einer vordefinierten Schwelle liegt. Die Schwelle kann in Ausführungsformen bei 1 Milliohm liegen. Alternativ oder ergänzend kann der Widerstand von einem Bediener eingegeben werden. Vorteilhaft kann so die Messgenauigkeit weiter verbessert werden durch Reduzierung des ermittelten Widerstandes von Batterie und elektrisch leitenden Verbindungselementen um den Widerstand der elektrisch leitenden Verbindungselemente.

Alternativ können die erste Stromstärke und die zweite Stromstärke durch eine Regelung konstant gehalten werden. Vorteilhaft kann so möglichen Widerstandsänderungen von ohmschen Bauteilen bzgl. Alter, Erwärmung oder anderer Umwelteinflüsse entgegengetreten werden, welche die Messqualität vermindern würden.

Die erste Stromstärke und die zweite Stromstärke können ein Verhältnis von 1 zu 2 aufweisen. Beispielhaft kann die erste Stromstärke 4,5 A und die zweite Stromstärke 9,0 A betragen. Die gewählten Stromstärken erlauben vorteilhaft die Messung des Innenwiderstands bei Kapazitäten der elektrischen Energiespeicher zwischen 1 Ah und 100 Ah, insbesondere zwischen 1 Ah und 50 Ah, da die Belastung der Batterie und die sich ergebende Spannungsdifferenz ausgewogen sind. Werden optional mehr als 2 Stromstärken bei der periodischen Messung eingesetzt, zum Beispiel bei der Messung eines Energiespeichers mit mehr als 100 Ah, insbesondere von mehr als 200 Ah, kann, bezogen auf die vorherige Stromstärke, jede weitere Stromstärke jeweils um den Betrag der ersten Stromstärke erhöht sein.

Ein zweiter Aspekt betrifft eine Steuerung zur Ermittlung eines Innenwiderstandes eines wiederaufladbaren elektrischen Energiespeichers. Die Steuerung kann dabei ferner dazu ausgebildet sein, die Schritte des Ausführungsbeispiels des ersten Aspekts sowie einige oder mehrere der oben genannten optionalen Schritte auszuführen. Vorteilhaft kann so eine preisgünstige Messeinrichtung zur Ermittlung eines Innenwiderstandes von wiederaufladbaren elektrischen Energiespeichern, zum Beispiel in Form von Batterien, bereitgestellt werden. Die Steuerung kann der Messeinrichtung entsprechen. Die Steuerung kann in die Batterie integriert sein. Der Innenwiderstand kann durch ein (beispielsweise lineare) Anzeige am Gehäuse der Batterie angezeigt werden. Weiter vorteilhaft kann die Steuerung dazu ausgelegt sein, in eine Vorrichtung (beispielsweise in ein Fahrzeug oder eine unterbrechungsfreie Stromversorgung) funktional integriert zu werden.

Optional kann die Steuerung ferner dazu ausgebildet sein, den Innenwiderstand (d.h. die Impedanz) in regelmäßigen Zeitabständen zu ermitteln und die Änderungstendenz zu analysieren. So kann bei festgelegten Abweichungen des Innenwiderstandes der Benutzer über den Zustand der Batterie informiert werden. Vorteilhaft ist es mit diesem Mess- und Auswerteverfahren möglich, eine schleichende oder eine plötzliche Änderung des Innenwiderstands der Batterie zu erkennen oder zu unterscheiden. Aus diesem Wert kann ferner ein Alterungsprozess der Batterie abgeleitet werden und ferner kann ein Defekt der Batterie rechtzeitig erkannt werden.

Ein dritter Aspekt betrifft eine unterbrechungsfreie Stromversorgung (USV). Diese kann einen wiederaufladbaren elektrischen Energiespeicher umfassen oder damit elektrisch leitend verbindbar sein. Sie kann die Steuerung zur Ermittlung eines Innenwiderstandes des wiederaufladbaren elektrischen Energiespeichers gemäß dem zweiten Aspekt umfassen. Vorteilhaft kann so in die unterbrechungsfreie Stromversorgung eine preiswerte Überwachungsfunktion integriert werden, die auf Basis des ermittelten Innenwiderstandes der angeschlossenen Batterie deren Funktionsfähigkeit überprüfen kann.

Ein wiederaufladbarer elektrischer Energiespeicher kann als Batterie ausgeführt sein, der elektrische Energie auf elektrochemischer Basis speichert. Als Batterietypen kommen Akkumulatoren auf Lithium-, Blei-, Nickel-, Natrium-, Silber-, Zinnbasis zum Einsatz, ohne auf diese Ausführungsarten beschränkt zu sein.

Ein Messvorgang kann eine Mehrzahl der periodisch umgeschalteten ersten und zweiten Stromstärken umfassen. Er kann bei Bedarf auch weitere Stromstärken umfassen, wie oben erläutert ist. Typisch kann der Messvorgang zwischen 30 und 60 Messperioden, insbesondere 40 Messperioden umfassen, wobei jede Messperiode die Entnahme der ersten Stromstärke und anschließend die Entnahme der zweiten Stromstärke umfassen kann. Die Messperioden können sich während des Messvorgangs unmittelbar aneinander anschließen.

Ein Tastgrad kann für eine periodische Folge von Impulsen (beispielsweise Stromstärken) das Verhältnis der Impulsdauer (d.h. der jeweiligen Dauern) zur Periodendauer angeben.

Nachfolgend wird die Erfindung unter Bezugnahme auf die anliegenden Zeichnungen anhand bevorzugter Ausführungsformen, die wahlweise miteinander kombinierbar sind, näher erläutert.

Es zeigen:

Fig. 1 ein Ablaufdiagramm für ein Verfahren zur Ermittlung eines Innenwiderstandes eines wiederaufladbaren elektrischen Energiespeichers gemäß einer Ausführungsform des ersten Aspekts,

Fig. 2 ein schematisches Strom-Spannungsverlaufsdiagramm einer idealisierten Batterie während eines Messvorgangs zur Feststellung des Innenwiderstandes der Batterie mit zwei Stromstärken gemäß einer Ausführungsform eines jeden Aspekts,

Fig. 3    ein schematisches Strom-Spannungsverlaufsdiagramm einer realen Batterie während eines Messvorgangs zur Feststellung des Innenwiderstandes der Batterie mit zwei Stromstärken gemäß einer Ausführungsform eines jeden Aspekts,

Fig. 4    eine schematische Darstellung einer steuerbaren Messchaltung mit angeschlossener Batterie zur Ermittlung eines Innenwiderstandes der Batterie gemäß einer Ausführungsform eines jeden Aspekts,

Fig. 5    eine schematische Darstellung einer elektrischen Schaltung einer Steuerung mit angeschlossener Batterie zur Ermittlung eines Innenwiderstandes der Batterie gemäß einer Ausführungsform des zweiten Aspekts, und

Fig. 6    eine schematische Darstellung einer unterbrechungsfreien Stromversorgung gemäß einer Ausführungsform des dritten Aspekts.

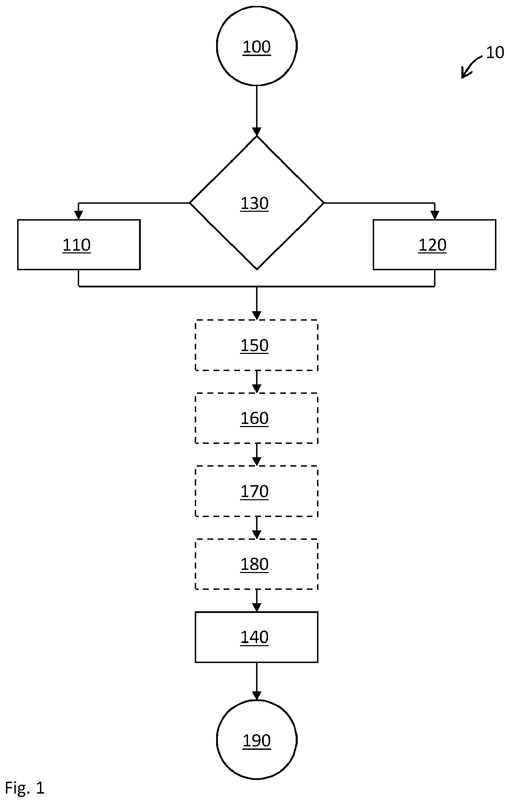

Fig. 1 betrifft in einem ersten Aspekt ein Verfahren 10 zur Ermittlung eines Innenwiderstandes eines wiederraufladbaren elektrischen Energiespeichers. Der Energiespeicher ist nachfolgend allgemein mit Bezugszeichen 400 bezeichnet. Der elektrischen Energiespeicher 400 ist als Batterie ausgebildet, die auf verschiedenen chemischen Prinzipien aufgebaut sein kann.

Das Verfahren 10 umfasst in einem ersten Schritt ein Erfassen 110 einer ersten Spannung des Energiespeichers 400, während eine erste Stromstärke dem Energiespeicher 400 entnommen wird. Weiter umfasst das Verfahren 10 in einem zweiten Schritt ein Erfassen 120 einer zweiten Spannung des Energiespeichers 400, während eine zweite Stromstärke dem Energiespeicher 400 entnommen wird. Die zweite Stromstärke ist dabei größer als die erste Stromstärke. Ergänzend umfasst das Verfahren 10 ein periodisches Umschalten 130 zwischen der Entnahme 110 der ersten Stromstärke und der Entnahme 120 der zweiten Stromstärke. Mit anderen Worten wird in einer ersten Periode zuerst die erste Stromstärke entnommen. Anschließend wird die zweite Stromstärke entnommen. Daran anschließend wird in einer zweiten Periode wiederum die erste Stromstärke entnommen und daran anschließend die zweite Stromstärke entnommen und so fort.

Weiter kann das Verfahren 10 den Innenwiderstand ermitteln in einem Schritt 140, basierend auf den in den Schritten 110 und 120 erfassten ersten und zweiten Spannungen, die bei den periodisch umgeschalteten ersten und zweiten Stromstärken erfasst sind.

Beispielsweise kann der Innenwiderstand mit einem einheitlichen Messverfahren für Batterien 400 mit einer Kapazität zwischen 1 Ah bis zu 100 Ah ermittelt werden, d.h. der Innenwiderstand mit ausreichender Genauigkeit gemessen werden. Bei Batteriekapazitäten bis zu 50 Ah wird dabei eine verbesserte Messgenauigkeit erreicht.

Weiter kann das Verfahren 10 optional den Innenwiderstand basierend auf einer Teilmenge 209 der erfassten ersten und zweiten Spannungen ermitteln, beispielsweise durch einen entsprechenden Verarbeitungsschritt 150 des Verfahrens 10. Ein Messvorgang wird hierin mit Bezugszeichen 208 und gegebenenfalls die Teilmenge mit Bezugszeichen 209 bezeichnet.

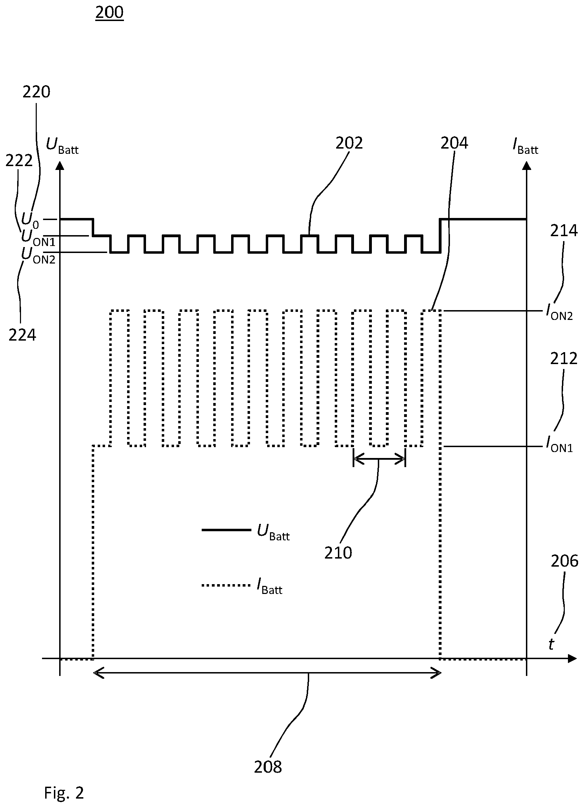

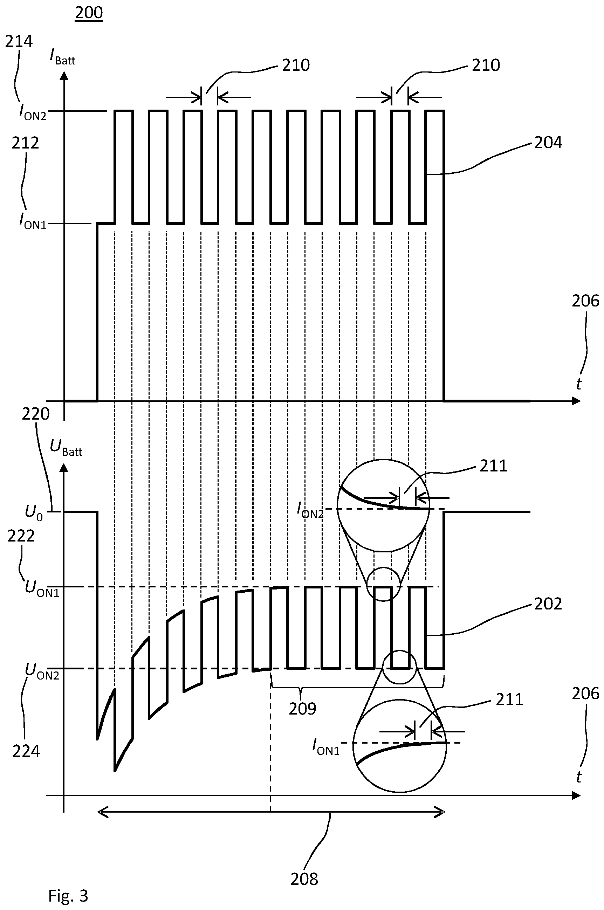

Dabei wird die Beobachtung ausgenutzt, dass zu Beginn einer periodischen Stromentnahme die allgemein mit Bezugszeichen 202 bezeichnete Spannung an den Batterieklemmen stark einbricht und/oder sich in den ersten Perioden auch deutlich verändert. Letzteres kann bedeuten, dass sich die Batteriespannung während einer konstanten Stromentnahme verändert, d.h. während der jeweiligen Dauer, die nachfolgend mit Bezugszeichen 210 bezeichnet wird. Dabei nimmt bei jeder weiteren Periode die Spannung insgesamt zu bei gleichzeitiger kleiner werdender Spannungsdifferenz zur vorhergehenden Periode. Nach einer Anzahl von Messperioden mit den verschiedenen Stromstärken erreicht die Spannung einen relativ konstanten Wert. Entsprechend wird unter Ausblendung der starken Spannungseinbrüche zu Beginn eines Messvorgangs die relativ konstante Spannung zur Ermittlung des Innenwiderstandes berücksichtigt. So wird eine Beschränkung auf die konstanten Spannungswerte bei der jeweiligen Stromentnahme erreicht. Näher erläutert wird diese Eigenschaft mit den Fig. 2 und 3, siehe unten.

Beispielsweise können aus 40 Messperioden, wobei jede Messperiode die Entnahme der ersten Stromstärke und anschließend die Entnahme der zweiten Stromstärke umfasst, die letzten 10 Messperioden der Teilmenge zum Ende eines Messvorgangs entsprechen. Alternativ können die ersten 30 Messperioden der Teilmenge zum Anfang eines Messvorgangs entsprechen. Es kann auch vorgesehen sein, eine Kombination beider Teilmengen zu benutzen. Dadurch kann vorteilhaft ein mittlerer Bereich der jeweiligen gemessenen Spannungen ausgewählt werden.

Da die erste Spannung und die zweite Spannung während der jeweiligen Stromentnahme variieren kann, kann optional durch die Mittelung oder Medianbildung der einzelnen gemessenen Spannungsverläufe bei der jeweiligen Stromentnahme die Messgenauigkeit weiter verbessert werden. Beispielsweise kann die Mittelung gemäß des RMS-Verfahrens (für "Root mean square", auf Deutsch Quadratisches Mittel oder Effektivwert genannt) erfolgen.

Die Teilmenge der erfassten ersten und zweiten Spannungen kann optional eine zum zeitlichen Ende einer konstanten (ersten oder zweiten) Stromstärke hin erfasste Teilmenge der ersten und zweiten Spannungen umfassen, beispielsweise durch einen Verarbeitungsschritt 160. Die Spannungsmessung kann während der

hierin mit Bezugzeichen 210 bezeichneten Dauer der jeweiligen Stromstärke erfolgen. Gegebenenfalls wird der Abschnitt der Erfassung mit Bezugzeichen 211 bezeichnet. Mit anderen Worten wird der Spannungsverlauf bei konstanter Stromentnahme nicht vollständig berücksichtigt. Stattdessen wird nur ein Abschnitt 211 des Spannungsverlaufs berücksichtigt, hier der hintere Abschnitt 211 zum zeitlichen Ende des entnommenen konstanten Stroms, d.h. zum Ende der Dauer 210. Entsprechend wird eine am Anfang eines Messvorgangs erfasste Teilmenge der ersten und zweiten Spannungen ausgeschlossen. Für dritte und weitere Spannungen, die auf dritten und weiteren Stromentnahmen basieren, gilt das entsprechend.

Optional kann die erfasste Teilmenge 209 der ersten und zweiten Spannungen eine vorgegebene Anzahl von Spannungen sein. Beispielsweise können die letzten 25% der erfassten Spannungen der Teilmenge 209 zum Ende eines Messvorgangs 208 entsprechen. Es können auch die letzten 20% oder 30% der erfassten Spannungen der Teilmenge zum Ende eines Messvorgangs 208 entsprechen.

Weiter optional kann das Verhältnis der erfassten und ausgeschlossenen ersten und zweiten Spannungen eingestellt werden. Dies kann automatisch erfolgen auf Basis bekannter Eigenschaften der Batterie 400. Es kann alternativ oder ergänzend auch durch Benutzereingaben bestimmt werden.

Während des ausgeschlossenen Anfangs des Messvorgangs kann optional eine Änderungsrate der ersten Spannung und/oder der zweiten Spannung größer als ein erster Schwellwert sein, beispielsweise gemäß einem entsprechenden Verarbeitungsschritt 170 des Verfahrens 10. Ergänzend oder alternativ kann während der zum Ende des Messvorgangs 210 hin erfassten Teilmenge 209 eine Änderungsrate der ersten Spannung und/oder der zweiten Spannung kleiner als ein zweiter Schwellwert sein, beispielsweise gemäß einem entsprechenden Verarbeitungsschritt 170 des Verfahrens 10. Dabei kann sich die Änderungsrate auf aufeinander folgende Werte der ersten Spannung und/oder der zweiten Spannung beziehen. Alternativ können auch nicht aufeinanderfolgende Werte der ersten Spannung und/oder der zweiten Spannung für den Schwellwert berücksichtigt werden. Dies kann jede 2. oder jede 3. Spannung sein. Weiter kann der zweite Schwellwert kleiner oder gleich des ersten Schwellwerts sein.

Vorteilhaft können so erste Spannungen und/oder zweite Spannungen mit ähnlichen Werten für eine Auswertung berücksichtigt werden. Somit kann die Auswertequalität verbessert werden. Weiter vorteilhaft ist es, verschiedene Änderungsraten berücksichtigen zu können. So kann auf die Eigenschaften der jeweils vorliegenden Batterie flexibel reagiert werden.

Eine weitere Verbesserung kann durch die Wählbarkeit des ersten Schwellwerts und des zweiten Schwellwerts erzielt werden, um Besonderheiten bestimmter wiederaufladbarer Batterien 400 zu berücksichtigen. Die Bestimmung des ersten Schwellwerts und/oder des zweiten Schwellwerts kann automatisch erfolgen zum Beispiel auf Basis erkannter Eigenschaften der Batterie, des chemischen Prinzips oder der Kapazität. Es kann alternativ oder ergänzend auch durch Benutzereingabe bestimmt werden.

Zur Ermittlung des Innenwiderstandes kann je Dauer der ersten und zweiten Stromstärke die erste beziehungsweise zweite Spannung nur in einem Abschnitt 211 der Dauer 210 erfasst werden, beispielsweise durch einen entsprechenden Verarbeitungsschritt 180 des Verfahrens. Optional kann die Erfassung zum Ende oder in einem letzten Abschnitt 211 der Dauer 210 der ersten beziehungsweise zweiten Stromstärke erfolgen. Beispielsweise kann der letzte Abschnitt 211 der Dauer 210 ein Viertel der Dauer, d.h. 25%, der ersten und zweiten Stromstärke beziehungsweise der ersten beziehungsweise zweiten Spannung umfassen. Er kann aber auch 20% oder 30% der Dauer umfassen. Alternativ oder ergänzend kann die Erfassung auch zum Anfang oder in einem ersten Abschnitt der Dauer 210 der ersten beziehungsweise zweiten Stromstärke erfolgen. Die Bestimmung der Dauer 210 und die Positionierung des Abschnitts 211 darin (beispielsweise als letzte oder erster Abschnitt) kann dabei automatisch erfolgen, zum Beispiel auf Basis erkannter Eigenschaften der Batterie 400, des chemischen Prinzips der Batterie 400 oder der Kapazität der Batterie 400. Sie kann optional auch aus dem Spannungsverlauf der ersten oder zweiten Spannung während der Dauer abgeleitet werden. Sie kann alternativ oder ergänzend auch durch Benutzereingabe bestimmt werden. Weiter optional kann zwischen der Erfassung des ersten Abschnitts und der Erfassung des letzten Abschnitts 211 der Spannung umgeschaltet werden. Das Umschalten kann auf einem Schwellwert basieren. In Ausführungsformen kann der Schwellwert auf der Änderungsrate der ersten Spannung und/oder der zweiten Spannung basieren.

Es ist zu beobachten, dass während der Dauer 210 der ersten und zweiten Stromstärke sich die erste bzw. zweite Spannung verändern kann. Entsprechend können durch die nur teilweise Berücksichtigung der Spannungen (der Spannungsverläufe) in einem Abschnitt 211 die zur Weiterverarbeitung bestimmten Werte vorteilhaft eingegrenzt werden, zum Beispiel auf die jeweils höchsten Werte der ersten beziehungsweise zweiten Spannung. Diese können auch am Anfang oder in einem ersten Abschnitt der Dauer liegen. Näher erläutert wird diese Eigenschaft mit den Figuren 2 und 3, siehe unten.

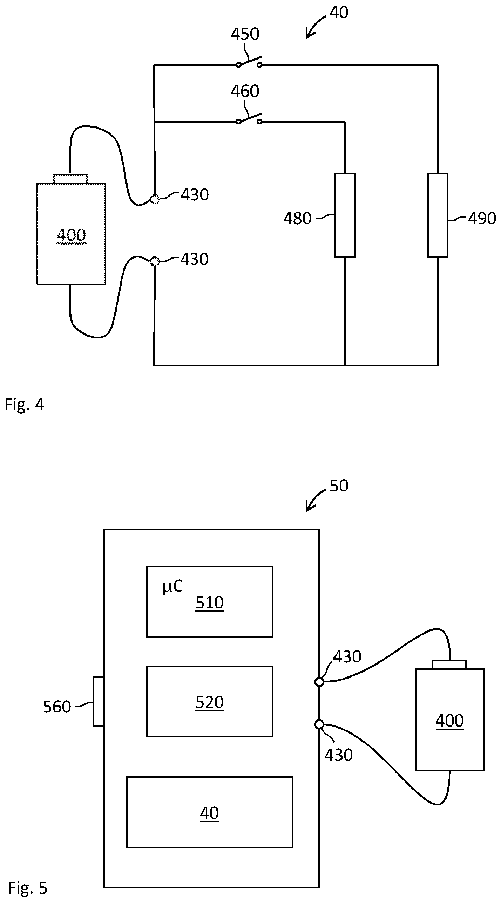

Die erste und zweite Stromstärke können jeweils konstant sein. Sie können dabei einen als Rechteck ausgeprägten Verlauf der Stromstärke aufweisen (siehe beispielsweise Fig. 3 und 4). Vorteilhaft kann der Verlauf durch Schalter realisiert werden, die zum Beispiel als Relais oder Transistoren (beispielsweise Feldeffekttransistoren) ausgeführt sein können und somit eine einfache und kostengünstige Realisierung erlauben.

Die Dauer der Entnahme der ersten und zweiten Stromstärke kann gleich sein (siehe beispielsweise Fig. 3 und 4). Ergänzend oder alternativ kann ein Tastgrad der ersten und zweiten Stromstärke von der Periodendauer des Umschaltens unabhängig sein. Weiter ergänzend oder alternativ kann eine Frequenz des periodischen Umschaltens von der Kapazität der Batterie unabhängig sein. Alternativ kann der Tastgrad auch an die Kapazität der Batterie angepasst werden. Vorteilhaft kann so für viele Batterietypen und Kapazitäten eine identische Einstellung beibehalten werden, was den Installations- und Wartungsaufwand reduziert. Weiter vorteilhaft kann für besondere Batterien und/oder Kapazitäten durch Anpassung des Tastgrades die Messgenauigkeit verbessert werden.

Die Batterie umfasst elektrochemische Zellen. Dabei kann eine Nennspannung der Batterie im Bereich von 24 V bis 48 V liegen. Ergänzend oder alternativ kann eine Kapazität der Batterie im Bereich von 1 Ah bis 50 Ah liegen. Alternativ können auch Kapazitäten bis zu 100 Ah oder bis zu 200 Ah zum Einsatz kommen in Abhängigkeit von der geforderten Messgenauigkeit. Darüber hinaus kann bei Kapazitäten über 200 Ah in Ergänzung der ersten Stromstärke und der zweiten Stromstärke noch eine dritte Stromstärke und ggf. optional noch eine vierte Stromstärke und ggf. optional noch eine fünfte Stromstärke der Batterie entnommen werden, wie bereits oben vermerkt. Alle jeweils gewählten Stromstärken werden periodisch umgeschaltet. Vorteilhaft kann so die Messgenauigkeit bei großen Batteriekapazitäten erhöht werden.

Die Fig. 2 zeigt schematisch ein Strom-Spannungsverlaufsdiagramm 200 einer idealisierten Batterie während eines Messvorgangs 208 zur Feststellung des Innenwiderstandes der Batterie 400 mit zwei Stromstärken 212 und 214. Auf der Ordinate sind die entnommene Stromstärke 204 und die gemessene Batteriespannung 202 aufgetragen, die Abszisse beschreibt die Zeit 206. Mit dem Einsetzen des Messvorgangs 208 wird die erste Stromstärke 212 bereitgestellt, die während des gesamten Messvorgangs 208 fließt. Sie bildet eine Art Offset, zu der regelmäßig ein Zusatzstrom hinzugefügt wird zur Bildung der zweiten Stromstärke 214. Korrespondierend zur Stromstärke 204 reduziert sich die Ausgangsspannung 202 der Batterie 400. Bei der ersten (kleineren) Stromstärke 212 wird die Leerlaufspannung 220 der Batterie 400 um einen ersten Betrag reduziert auf die erste Spannung 222. Bei der zweiten (größeren) Stromstärke 214 wird die Leerlaufspannung 220 der Batterie 400 um einen weiteren Betrag reduziert auf die zweite Spannung 224. Nach Ablauf des Messvorgangs 208 ist die Stromstärke 204 wieder null und die Leerlaufspannung 220 der Batterie (näherungsweise) wieder bei ihrem ursprünglichen Wert. Die Veränderungen der Spannung 202 korrespondieren mit den Veränderungen der Stromstärke 204. Bei realen Batterien ergibt sich ein modifiziertes Bild.

Die Fig. 3 zeigt schematisch ein Strom-Spannungsverlaufsdiagramm 200 einer realen Batterie 400 während eines Messvorgangs 208 zur Feststellung des Innenwiderstandes der Batterie 400 mit zwei Stromstärken 212 und 214. Fig. 3 zeigt eine mit Fig. 2 vergleichbare Betrachtung von entnommener Stromstärken 204 und Batteriespannungen 202 bei dem Messvorgang 208. Der Übersichtlichkeit halber sind hier die Stromstärke 204 und die resultierende Batteriespannung in getrennten Diagrammen dargestellt, bei denen die Abszissen der Zeit 206 einander entsprechen. Der im oberen Diagramm dargestellte Verlauf der Stromstärken 204 ist mit dem der Fig. 2 vergleichbar. Eine deutliche Abweichung ist bei dem Verlauf der Batteriespannung 202 zu beobachten. Wie bereits oben dargelegt, bricht die Batteriespannung 202 zu Beginn des Messvorgangs 208 stark ein. Im Laufe von weiteren Messperioden mit der Umschaltung 130 zwischen den beiden Stromstärken 212 und 214 erholt sich die Spannung 202 schrittweise, um nach einer gewissen Anzahl von Messperioden einen näherungsweise konstanten Wert einzunehmen.

Weiter ist dem Diagramm 200 die Änderung der Spannung 202 bereits während der Entnahme einer Stromstärke zu entnehmen. Darüber hinaus ist die Batteriespannung bei genauer Betrachtung auch nach einer gewissen Anzahl von Messperioden nicht konstant innerhalb der jeweiligen Dauer 210. Dabei steigt der untere Spannungswert 224 beim Anliegen der hohen Stromstärke 214 an, während der obere Spannungswert 222 beim Anliegen der niedrigeren Stromstärke 212 abnimmt, wie im Diagramm 200 in den Kreisausschnitten schematisch eingeblendet ist. Beispielsweise kehrt sich der Verlauf des oberen Spannungswertes 222 innerhalb der jeweiligen Dauer nach Erreichen des im Vergleich zu den vorherigen Messperioden näherungsweise konstanten Wertes, d.h. im Abschnitt 209, um. Entsprechend kann es zweckmäßig sein, die erfassten Teilmengen 209 der ersten und der zweiten Spannung 222 und 224 im Verlauf der Messung zu variieren.

Gemäß Fig. 4 wird die Batterie 400 zur Entnahme der ersten Stromstärke 212 über einen ersten Messwiderstand 480 entladen und zur Entnahme der zweiten Stromstärke 214 über einen zweiten Messwiderstand 490. Alternativ kann die Entnahme der zweiten Stromstärke 214 über eine Parallelschaltung des ersten Messwiderstands 480 und des zweiten Messwiderstands 490 erfolgen. Dabei können Messwerte der Messwiderstände 480 und/oder 490 einer Messeinrichtung 50 (beispielsweise in Fig. 5 gezeigt), auf denen die erste Stromstärke 212 und die zweite Stromstärke 214 basieren, in der Messeinrichtung 50 hinterlegt sein. Die Messwerte können bei einer Kalibrierung der Messeinrichtung 50 ermittelt werden. Optional können dabei die Messwerte der Messwiderstände 480 und/oder 490 der Messeinrichtung 50 mindestens zehnfach größer als der Innenwiderstand der Batterie 400 sein. Weiter optional können die Messwiderstände 480 und/oder 490 für die erste Stromstärke 7,5 Ohm betragen und für die zweite Stromstärke 3,75 Ohm betragen. Vorteilhaft können so Ladeströme von 4,5 A bzw. 9,0 A erzielt werden, die zur Verbesserung der Messgenauigkeit beitragen. Weiter vorteilhaft kann durch die Hinterlegung der Messwerte oder Nennwerte der Messwiderstände 480 und/oder 490 in der Messeinrichtung 50 auf die Messung der ersten Stromstärke und der zweiten Stromstärke verzichtet werden, was die Messeinrichtung 50 vereinfacht.

Mit anderen Worten zeigt Fig. 4 eine schematische Darstellung einer elektrischen Schaltung 40 (beispielsweise gesteuert von einer Steuerung) mit angeschlossener Batterie 400 zur Ermittlung eines Innenwiderstandes der Batterie 400. Die beschriebenen Verbindungen sind elektrisch leitende Verbindungen. Die strichliert dargestellte Batterie 400 wird durch das Ersatzschaltbild einer Batterie 400 bestehend aus einem in Reihe geschalteten Innenwiderstands und aus einer idealen Gleichspannungsquelle beschrieben.

Der Pluspol der Batterie 400 ist über Kontaktpunkte 430 mit der Schaltung 40 verbunden. Der obere Kontaktpunkt 430 ist mit dem ersten Schalter 450 und gleichzeitig mit dem zweiten Schalter 460 verbunden. Der erste Schalter 450 ist mit dem ersten Messwiderstand 480 verbunden. Der zweite Schalter 460 ist mit dem zweiten Messwiderstand 490 verbunden. Die Werte der Messwiderstände können zum Beispiel durch eine Kalibrierung der Schaltung bekannt sein und in der zugehörigen Steuerung hinterlegt sein. Der erste Messwiderstand 480 und der zweite Messwiderstand 490 sind gemeinsam mit dem unteren Kontaktpunkt 430 verbunden. Der untere Kontaktpunkt 430 ist mit dem Minuspol der Batterie verbunden.

Es sind eine Vielzahl von Batterietypen anschließbar, die Akkumulatoren auf Lithium-, Blei-, Nickel-, Natrium-, Silber- und Zinnbasis umfassen können. Typische Spannungen der Batterie liegen zwischen 24 Volt und 48 Volt, ohne auf diese beschränkt zu sein. Die Kontaktpunkte 430 sind als elektrisch leitende Verbindungselemente ausgeführt. Diese können (nicht dargestellte) Polklemmen zum Anschluss an die Batterie 400 und an den Polklemmen befestigte Leitungen umfassen. Die Leitungen können an ihrem anderen Ende an Verbinder angeschlossen sein, die einen elektrisch leitenden Kontakt zur Schaltung der Steuerung herstellen. Der ohmsche Widerstand der elektrisch leitenden Verbindungselemente kann bekannt sein und in der zugehörigen Steuerung 50 hinterlegt sein. Die ersten und zweiten Messwiderstände 480 und/oder 490 können durch einzelne ohmsche Widerstände gebildet werden. Sie können Werte von 7,5 Ohm und 3,75 Ohm haben bei alternierender Schalterbetätigung. Alternativ können beide Messwiderstände 480 und/oder 490 mit 7,5 Ohm ausgeführt sein, insbesondere wenn der erste Schalter 450 für die erste Stromentnahme stets geschlossen bleibt, während der zweite Schalter 460 für die erste Stromstärke 212 geöffnet ist und nur für die zweite Stromstärke 214 geschlossen wird. In letzterem Fall kann der Index "ON" und "OFF" in den Fig. 2 und 3 dem Zustand des zweiten Schalters 460 entsprechen.

Zur thermischen Entlastung können die Messwiderstände 480 und/oder 490 jeweils als eine Parallelschaltung von zwei oder mehr diskreten Widerständen ausgebildet sein.

Die Schalter 450 und/oder 460 können als Relais ausgebildet sein. Alternativ können die Schalter 450 und/oder 460 auch als Transistoren ausgebildet sein, insbesondere als Feldeffekttransistoren. Bei einer Messung mittels Zuschaltung des zweiten Messwiderstands 490 für die zweite Stromstärke kann der erste Schalter als Relais ausgebildet sein (für das langsame Schalten am Anfang und Ende des Messvorgangs 208) und der zweite Schalter kann als Transistor ausgebildet sein (für das schnelle Umschalten 130).

Die Ansteuerung der Schalter kann durch eine Steuerung 50 (beispielsweise einen Prozessor der zugehörigen Steuerung) erfolgen, wie nachfolgend näher erläutert wird.

Beim periodischen Umschalten 130 zwischen der ersten und zweiten Stromstärke 212 und 214 können die oben genannten Schalter 450 und 460 als Feldeffekttransistoren ausgeführt sein (in Fig. 4 nicht gezeigt). In diesem Fall wird mittels Feldeffekttransistoren zwischen dem ersten und dem zweiten Widerstand 480 und 490 umgeschaltet. Alternativ kann mittels eines Feldeffekttransistors der zweite Messwiderstand 490 parallel zum ersten Messwiderstand zugeschaltet werden.

Dabei kann eine Frequenz des periodischen Umschaltens 130 größer als oder gleich 100 Hz sein. So kann die Frequenz des periodischen Umschaltens zwischen 100 Hz und 5 kHz liegen. Vorteilhaft wird so die Genauigkeit der Messung weiter erhöht. Weiter vorteilhaft wird durch die Verwendung der Feldeffekttransistoren eine praktische Beschränkung der Höhe der Umschaltfrequenz vermieden. Ergänzend wird Bauraum bei der Realisierung der Lösung gespart.

Die Messwerte können um den Widerstand von elektrisch leitenden Verbindungselementen zwischen der Batterie 400 und der Messeinrichtung (beispielsweise der Schaltung 40 und/oder der Steuerung 50) korrigiert werden. Dabei kann der Widerstand auf den ohmschen Anteil (realer Anteil der Impedanz) beschränkt sein. Weiter optional kann der Widerstand der elektrisch leitenden Verbindungselementen in der Messeinrichtung 50 hinterlegt sein. Dies kann ein bei der Fertigung der Messeinrichtung 50 gemessener Wert sein. Alternativ kann es auch ein konstanter Wert sein, der bei der Fertigung hinterlegt wird. Weiter alternativ kann der Wert auch ignoriert werden, wenn er unter einer vordefinierten Schwelle liegt. Die Schwelle kann in Ausführungsformen bei 1 Milliohm liegen. Alternativ oder ergänzend kann der Widerstand von einem Bediener eingegeben werden. Vorteilhaft kann so die Messgenauigkeit weiter verbessert werden durch Reduzierung des ermittelten Widerstandes von Batterie und elektrisch leitenden Verbindungselementen um den Widerstand der elektrisch leitenden Verbindungselemente.

Alternativ können die erste Stromstärke 212

und die zweite Stromstärke 214 durch eine Regelung konstant gehalten werden (in Fig. 4 nicht gezeigt). Vorteilhaft kann so möglichen Widerstandsänderungen von ohmschen Bauteilen bzgl. Alterung, Erwärmung oder anderer Umwelteinflüsse entgegengetreten werden, die die Messqualität vermindern würden.

In jedem Ausführungsbeispiel kann die erste Stromstärke 212 und die zweite Stromstärke 214 können ein Verhältnis von 1 zu 2 aufweisen. Beispielsweise kann die erste Stromstärke 4,5 A und die zweite Stromstärke 9,0 A betragen. Die gewählten Stromstärken erlauben vorteilhaft die Messung von Kapazitäten der Batterie zwischen 1 Ah und 100 Ah. Für eine erhöhte Messgenauigkeit (beispielsweise gegenüber der DC-Messung) liegt die Kapazität zwischen 1 Ah und 50 Ah. Werden optional mehr als 2 Stromstärken bei der periodischen Messung eingesetzt, zum Beispiel bei der Messung einer Batterie 400 mit mehr als 100 Ah, kann, bezogen auf die vorherige Stromstärke, jede weitere Stromstärke jeweils um den Betrag der ersten Stromstärke erhöht sein. Insbesondere bei einer Batteriekapazität von mehr als 200 Ah sind mehr als 2 Stromstärken für eine verbesserte Genauigkeit vorzusehen.

Gemäß Fig. 5 betrifft ein zweiter Aspekt eine Steuerung 50 zur Ermittlung eines Innenwiderstandes einer Batterie 400. Die Steuerung 50 kann der Messeinrichtung entsprechen und/oder die Schaltung 40 umfassen. Weiter vorteilhaft kann die Steuerung 50 dazu ausgelegt sein, in eine Vorrichtung funktional integriert zu werden.

Optional kann die Steuerung 50 ferner dazu ausgebildet sein, den Innenwiderstand (Impedanz) in regelmäßigen Zeitabständen zu ermitteln und die Änderungstendenz zu analysieren (beispielsweise durch entsprechende Anweisungen im Speicher 520 für den Prozessor oder Mikrocontroller 510). So kann bei festgelegten Abweichungen des Innenwiderstandes der Benutzer über den Zustand der Batterie 400 informiert werden. Vorteilhaft ist es mit diesem Mess- und Auswerteverfahren 10 möglich, eine schleichende oder eine plötzliche Änderung des Innenwiderstands der Batterie zu erkennen. Aus diesem Wert kann ferner ein Alterungsprozess der Batterie 400 abgeleitet werden und ferner kann ein Defekt der Batterie 400 rechtzeitig erkannt werden.

Mit anderen Worten zeigt Fig. 5 eine schematische Darstellung einer Steuerung 50 mit angeschlossener Batterie 400 zur Ermittlung eines Innenwiderstandes der Batterie, die die elektrische Schaltung 40 und weitere Elemente umfasst. Die Steuerung 50 umfasst zusätzlich einen Prozessor 510 zur Ablaufsteuerung der Steuerung 50, beispielsweise gemäß dem Verfahren 10. Weiter umfasst die Steuerung 50 einen Speicher 520, der ein Programm zur Ausführung der Messung zur Ermittlung eines Innenwiderstandes der angeschlossenen oder anschließbaren Batterie 400, optional sowie zur Speicherung der erfassten Messwerte und den daraus ermittelten Ergebnissen, umfasst. Weiter umfasst die Steuerung 50 die Anschlusspunkte 430 für die elektrische Kontaktierung der Batterie 400 optional sowie eine Datenschnittstelle 560 zur Ein- und Ausgabe von Daten.

Der Prozessor 510 steuert das Messverfahren zur Ermittlung eines Innenwiderstandes der angeschlossenen Batterie. Er steuert die Bereitstellung der ersten und zweiten (und ggf. weiteren) Stromstärken, die Erfassung der jeweiligen Batteriespannungen, ggf. die Ausblendung bestimmter erfasster Spannungen und/oder die Ausblendung bestimmter Phasen der jeweils erfassten Batteriespannung. Dabei wird zur Ermittlung eines Innenwiderstandes der Batterie der Unterschied der Spannungen und der Unterschied der Ströme der betrachteten Teilmengen der Messperioden ins Verhältnis gesetzt und um den Widerstand der Verbindungselemente zwischen Batterie und Steuerung reduziert.

Es kann der Innenwiderstand der Batterie 400 gemäß folgender Formel ermittelt werden

$$R_i = \left| \frac{\sum_{i=n-m+1}^{n} \frac{dU}{dI}}{m} \right| - R_{Verb}$$

Dabei ist $R_i$ der Innenwiderstand in Ohm der Batterie, n die Anzahl der Umschaltzyklen der verschiedenen Stromstärken des Messvorgangs, m die Anzahl der ausgewerteten Umschaltzyklen, dU der gemessene Spannungsunterschied bei den verschiedenen Stromstärken, dI der Stromunterschied der verschiedenen Stromstärken und $R_{Verb}$ der ohmsche Widerstand der Verbindungselemente zwischen Batterie und Steuerung. Bei einem Messverfahren 10 mit mehr als zwei verschiedenen Stromstärken 212 und 214 ist die Auswertung entsprechend anzupassen. Dies kann durch das ins Verhältnis setzen der effektiven Spannungen zu den effektiven Strömen geschehen. Dabei kann folgende Formel zur Anwendung kommen:

$$R_i = \frac{U_{eff}}{I_{eff}} .$$

$U_{eff}$ ist dabei die effektive Spannung aller gemessenen Spannungen, $I_{eff}$ ist dabei die effektive Stromstärke aller bereitgestellten Stromstärken.

Der Innenwiderstand der Batterie $R_i$ kann in regelmäßigen Zeitabständen ermittelt und seine Änderungstendenz analysiert werden. Bei festgelegten Abweichungen der Impedanz kann der Bediener über den Zustand der Batterie informiert werden. Entsprechend ist es mit diesem Mess- und Auswerteverfahren möglich, eine schleichende oder eine plötzliche Änderung des Innenwiderstandes der Batterie zu erkennen. Aus diesem Wert kann der Alterungsprozess analysiert und ein Defekt der Batterie rechtzeitig erkannt werden.

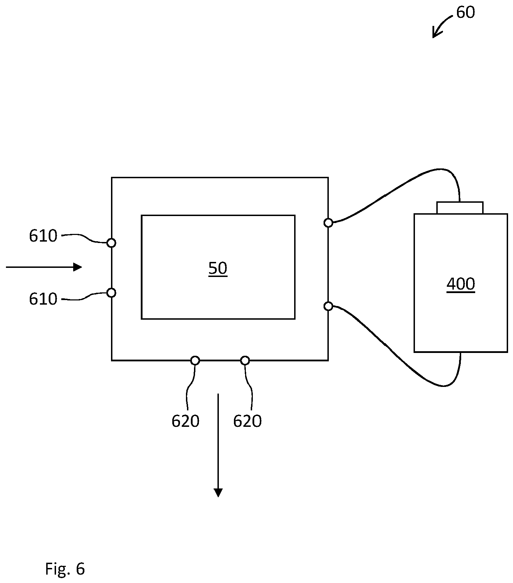

Fig. 6 zeigt schematisch gemäß einem dritten Aspekt eine Ausführungsform einer unterbrechungsfreien Stromversorgung (USV) 60. Diese kann eine Batterie 400 umfassen (in Fig. 6 nicht gezeigt) oder mit der Batterie elektrisch leitend verbindbar sein. Sie kann die Steuerung 50 zur Ermittlung eines Innenwiderstandes der Batterie 400 gemäß dem zweiten Aspekt umfassen. Vorteilhaft kann so in die unterbrechungsfreie Stromversorgung eine preiswerte Überwachungsfunktion integriert werden, die auf Basis des ermittelten Innenwiderstandes der angeschlossenen Batterie deren Funktionsfähigkeit überprüfen kann. Darüber hinaus zeigt Fig. 6 die Klemmen der Primärstromversorgung 610 sowie die Klemmen 620, die die Stromversorgung für die anzuschließenden Verbraucher bereitstellt,

Mit anderen Worten kann die Erfindung auch wie folgt dargestellt werden. Das hier beschriebene Mess- und Auswerteverfahren kann für die Ermittlung der Impedanz (des Innenwiderstandes) einer Batterie im Betrieb an einer unterbrechungsfreien Stromversorgung (USV) verwendet werden. Dieses Mess- und Auswerteverfahren kann eine Aussage über den Zustand der angeschlossenen Batterie liefern. Der Innenwiderstand (Impedanzwert) kann in regelmäßigen Zeitabständen ermittelt werden und die Änderungstendenz kann analysiert werden. Bei festgelegten Abweichungen des Innenwiderstands kann der Benutzer über den Zustand der Batterie informiert werden. Mit diesem Mess- und Auswerteverfahren ist es möglich, eine schleichende oder eine plötzliche Änderung der Impedanz der Batterie zu erkennen. Aus diesem Wert kann der Alterungsprozess analysiert und ein Defekt der Batterie rechtzeitig erkannt werden.

Die Impedanz einer Batterie bewegt sich im Bereich von wenigen Milliohm (bei den Batterien mit großen Kapazitäten) bis mehreren hundert Milliohm (bei den Batterien mit kleinen Kapazitäten). Eine unterbrechungsfreie Stromversorgung muss in der Lage sein, jede angeschlossene Batterie zu analysieren und unabhängig von Kapazität und Typ eine verlässliche Aussage über die Qualität der Batterie zu liefern.

Bisher bekannte Messverfahren der Batterieimpedanz (d.h. des Innenwiderstands) liefern entweder gute Ergebnisse, beispielsweise AC-Messungen (d.h. Alternating Current-Messung) mit Wechselspannung, oder werden zu ungenau bei höheren Batterie-Kapazitäten, beispielsweise DC-Messung (d.h. Direct Current-Messungen) mit Gleichspannungswerten. Allerdings benötigt die AC-Messung eine komplexe und kostenintensive Messeinrichtung, die für eine Massenproduktion der USV-Geräte nicht geeignet ist. Die DC-Messung ist dagegen einfach aufgebaut und für die Massenproduktion der USV-Geräte geeignet, liefert aber bei einem breiten Spektrum der angeschlossenen Batterien nicht die gewünschte Genauigkeit der Aussage über die Qualität der Batterie.

Das hier beschriebene Mess- und Auswerteverfahren basiert auf der kostengünstigeren DC-Messeinrichtung, wobei die Methode und das Auswerteverfahren neu entwickelt wurden, sodass auch bei den Batterien mit großen Kapazitäten die gewünschte Genauigkeit der Aussage erreicht wird.

Bei dem hier beschriebenen Mess- und Auswerteverfahren wird eine modifizierte DC-Messung als Messverfahren verwendet. Im Unterschied zu dem bekannten DC-Mess-Verfahren, wo die Messung der Leerlaufspannung und die Messung der Batteriespannung mit einem angeschlossenen Lastwiderstand das Ergebnis bereits liefert, werden beim erfindungsgemäßen Verfahren zwei unterschiedliche Lastwiderstände abwechselnd an der Batterie angeschlossen (siehe Fig. 4).

Eine Batterie 400 lässt sich als eine Serienschaltung einer idealen Spannungsquelle und eines Innenwiderstandes darstellen. Für die vollständige Messung werden nacheinander der erste Schalter 450 und der zweite Schalter 460 aktiviert (d.h. geschlossen oder elektrisch leitend). Bei Strombelastung mit der ersten Stromstärke 212 fällt am Innenwiderstand 480 eine Spannung ab. Bei der Strombelastung mit der zweiten Stromstärke 214, wenn der zweite Schalter 460 aktiviert ist, fällt am zweiten Messwiderstand 490 die Spannung ab. Der Innenwiderstand der Batterie lässt sich dann aus den beiden Werten der ersten Spannung 222 und der zweiten Spannung 224 und aus den bekannten ersten und zweiten Stromstärken 212 und 214 berechnen.

Der zweite Unterschied des Messverfahrens kann in der Dauer der Messung liegen. Bei dem bekannten DC-Messverfahren werden zwei Messungen durchgeführt, eine Leerlaufmessung und eine Belastungsmessung. Bei dem erfinderischen Mess- und Auswerteverfahren wird der Vorteil einer AC-Messung genutzt und die Batterie wird mehrmals in Folge belastet (siehe Fig. 5).

Bei dem erfindungsgemäßen Mess- und Auswerteverfahren kann die angeschlossene Batterie mehreren Rechteckimpulsen ausgesetzt werden. Die Gesamtdauer der Belastung, das erste Stromstärke- zu zweite Stromstärke-Verhältnis und die Impulsbreite können entsprechend der Batteriekapazität gewählt werden, um optimale Messung durchführen zu können und um sehr genaue Messwerte zu bekommen. In Ausführungsbeispielen kann die Dauer der Belastung mit der ersten Stromstärke zu der zweiten Stromstärke gleich sein. Die Gesamtdauer der Messung kann von den verwendeten Bauteilen abhängig sein.

Die Berechnung basiert auf der Ermittlung der Batteriespannung während der zweistufigen periodischen Belastung der Batterie. Der Widerstandswert für die Batterielaststromberechnung kann in der USV als zwei Konstanten hinterlegt werden, die Spannung wird von der USV erfasst. Aus diesem Grund kann auf eine separate Strommessung verzichtet werden. Der errechnete Widerstandswert kann bereinigt werden, indem der Widerstandswert der angeschlossen Leitungen und Klemmen subtrahiert wird. Eine Erweiterung der Messmethode für mehr Genauigkeit kann wie folgt ausgestaltet sein. Die in der Praxis erzielte Genauigkeit ist für die erfinderische Anwendung ausreichend. Mit zwei Belastungsstufen wird die gestellte Anforderung an die Genauigkeit bei den aktuell verwendeten Batterien bis zu 200 Ah erreicht, unabhängig von dem Batterietyp, bzw. der verwendeten chemischen Stoffe. Bei Verwendung von größeren Batteriekapazitäten oder/und bei höherer Anforderung an die Genauigkeit der Messung kann die Schaltung aus Fig. 4 um eine oder mehrere Stufen erweitert und das Berechnungsmodel angepasst werden. Die Genauigkeit der Messung kann durch weitere Maßnahmen verbessert werden, wie RMS-Berechnung von Spannungs- und Stromwerten, sowie durch die Anpassung der Schaltfrequenz der Schalter (zum Beispiel zwischen 100 Hz bis 5 kHz). Auch eine Erweiterung der Schaltung 40 durch weitere zusätzliche Schalter über die vorhandenen Schalter 450 und hinaus 460 bringt eine Verbesserung in der Genauigkeit, vor allem bei höheren Kapazitäten der Batterie, mit sich.

Untersuchungen haben gezeigt, dass eine herkömmliche DC-Messung keine notwendige Messgenauigkeit liefern kann, da bei nur einem (im erfindungsgemäßen Verfahren - ersten) Belastungsimpuls die Batteriespannung stark einbricht. Bei den weiteren Belastungsimpulsen bricht die Batteriespannung nicht so tief ein. Die Messgenauigkeit steigt mit jedem weiteren Impuls (siehe Fig. 3). Zur Auswertung und Berechnung können mehrere Impulse (z.B. die letzten 10) in der zweiten Hälfte des Messdurchganges, wenn die gemessene Spannung sich stabilisiert (keine größeren Schwingungen feststellbar sind, sich "beruhigt") hat, betrachtet werden. Zusätzlich, um die Messgenauigkeit zu erhöhen, kann die Messdatenerfassung im letzten Drittel eines Impulses vorgenommen werden. Ein Mittelwert aus mehreren Messwerten kann die Genauigkeit der Messung noch einmal erhöhen.

Mit Ausführungsbeispielen des erfindungsgemäßen Mess- und Auswerteverfahrens 10 lassen sich alle wiederaufladbaren elektrochemischen Batterien (Akkumulatoren), unabhängig von Typ und Kapazität, bewerten.

Des Weiteren besteht durch das beschriebene Mess- und Auswerteverfahren 10 die Möglichkeit, die Qualität der Installation, also der Strecke (Kabel, Klemmenverbindung, etc.) zwischen der USV und der Batterie zu berücksichtigen in entsprechenden Ausführungsbeispielen.

Obwohl die Erfindung in Bezug auf exemplarische Ausführungsbeispiele und Ausführungsformen beschrieben worden ist, ist für Fachkundige ersichtlich, dass verschiedene Änderungen vorgenommen werden können und Äquivalente als Ersatz verwendet werden können. Ferner können viele Modifikationen vorgenommen werden, um die Schaltung oder die Batterie an die Lehre der Erfindung anzupassen. Folglich ist die Erfindung nicht auf die offenbarten Ausführungsbeispiele beschränkt, sondern umfasst alle Ausführungsbeispiele, die in den Bereich der beigefügten Patentansprüche fallen.

**Bezugszeichenliste**

| | |
|---|---|
| 10 | Ablaufdiagramm für ein Verfahren zur Ermittlung eines Innenwiderstandes eines wiederraufladbaren elektrischen Energiespeichers |
| 40 | Schaltung zur Messung |
| 50 | Steuerung, insbesondere Messeinrichtung |
| 60 | Unterbrechungsfreie Stromversorgung |
| 100 | Start des Verfahrens |
| 110 | Erfassen einer ersten Spannung des Energiespeichers |
| 120 | Erfassen einer zweiten Spannung des Energiespeichers |
| 130 | Periodische Umschaltung |
| 140 | Ermitteln des Innenwiderstands des Energiespeichers |
| 150 | Teilmengenerfassung aller Spannungen |
| 160 | Teilmengenerfassung der Spannungen zum Ende des Messvorgangs |
| 170 | Erfassung gemäß einem Schwellwert der ersten Spannung und/oder der zweiten Spannung |
| 180 | Abschnitterfassung der ersten Spannung und/oder der zweiten Spannung |
| 190 | Verfahrensabschluss |
| 200 | Strom-Spannungsverlaufsdiagramm |
| 202 | Klemmenspannung $U_{Batt}$ des Energiespeichers, beispielsweise Spannungsverlauf an den Batterieklemmen |
| 204 | Energiespeicher entnommene Stromstärke $I_{Batt}$ |
| 206 | Zeit |
| 208 | Messvorgang |
| 209 | Ende des Messvorgangs |
| 210 | Dauer der ersten und/oder zweiten Stromstärke |
| 211 | Abschnitt der Dauer der ersten und/oder zweiten Stromstärke |
| 212 | Erste Stromstärke $I_{ON1}$ des Energiespeichers |
| 214 | Zweite Stromstärke $I_{ON2}$ des Energiespeichers |
| 220 | Nenn- oder Leerlaufspannung des Energiespeichers |
| 222 | Erste Spannung $U_{ON1}$ des Energiespeichers |
| 224 | Zweite Spannung $U_{ON2}$ des Energiespeichers |
| 400 | Elektrischer Energiespeicher, beispielsweise Batterie |
| 430 | Anschlusspunkte der Batterie an der Schaltung |
| 450 | Erster Schalter, beispielsweise erster Feldeffekttransistor |
| 460 | Zweiter Schalter, beispielsweise zweiter Feldeffekttransistor |
| 480 | Erster Messwiderstand |
| 490 | Zweiter Messwiderstand |
| 510 | Prozessor der Steuerung |
| 520 | Speicher der Steuerung |
| 560 | Datenleitungsanschlüsse |
| 610 | Klemmen der Primärstromversorgung |
| 620 | Klemmen der Stromversorgung für die anzuschließenden Verbraucher |

**Patentansprüche**

1. Verfahren (10) zur Ermittlung eines Innenwiderstandes eines wiederaufladbaren elektrischen Energiespeichers (400), umfassend:

   Erfassen (110) einer ersten Spannung (222) des Energiespeichers (400) während eine erste Stromstärke (212) dem Energiespeicher (400) entnommen wird;
   Erfassen (120) einer zweiten Spannung (224) des Energiespeichers (400) während eine zweite Stromstärke (214) dem Energiespeicher (400) entnommen wird, die größer als die erste Stromstärke (212) ist;
   wobei zwischen der Entnahme der ersten Stromstärke (212) und der Entnahme der zweiten Stromstärke (214) periodisch umgeschaltet (130) wird,
   Ermitteln (140) des Innenwiderstandes basierend auf den erfassten ersten und zweiten Spannungen (222, 224), die bei den periodisch umgeschalteten (130) ersten und zweiten Stromstärken (212, 214) erfasst sind.

2. Verfahren (10) nach Anspruch 1, wobei der Innenwiderstand basierend auf einer Teilmenge (209) der erfassten ersten und zweiten Spannungen (222, 224) ermittelt (140) wird.

3. Verfahren (10) nach Anspruch 2, wobei die Teilmenge (209) der erfassten ersten und zweiten Spannungen (222, 224) eine zum Ende eines Messvorgangs (208) hin erfasste Teilmenge der ersten und zweiten Spannungen (222, 224) umfasst und/oder eine am Anfang eines Messvorgangs (208) erfasste Teilmenge der ersten und zweiten Spannungen (222, 224) ausschließt.

4. Verfahren (10) nach Anspruch 3, wobei während des ausgeschlossenen Anfangs des Messvorgangs (208) eine Änderungsrate der ersten Spannung (222) und/oder der zweiten Spannung (224) größer als ein erster Schwellwert ist, und/oder

   wobei während der zum Ende des Messvorgangs (208) hin erfassten Teilmenge (209) eine Änderungsrate der ersten Spannung (222) und/oder der zweiten Spannung (224) kleiner als ein zweiter Schwellwert ist,
   optional wobei der zweite Schwellwert kleiner oder gleich dem ersten Schwellwert ist.

5. Verfahren (10) nach einem der Ansprüche 1 bis 4, wobei zur Ermittlung des Innenwiderstandes je Dauer (210) der ersten und zweiten Stromstärke (212, 214) die erste beziehungsweise zweite Spannung (222, 224) nur in einem Abschnitt (211) der Dauer (210) erfasst wird, optional zum Ende oder in einem letzten Viertel der Dauer (210) der ersten beziehungsweise zweiten Stromstärke (212, 214) erfasst wird.

6. Verfahren (10) nach einem der Ansprüche 1 bis 5, wobei die erste und zweite Stromstärke (222, 224) jeweils konstant sind mit einem als Rechteck ausgeprägten Verlauf der Stromstärke (204).

7. Verfahren (10) nach einem der Ansprüche 1 bis 6, wobei die Dauer (210) der Entnahme der ersten und zweiten Stromstärke (212, 214) gleich sind, und/oder

   wobei ein Tastgrad der Dauer (210) der ersten und zweiten Stromstärke (212, 214) anteilig an der Periodendauer des Umschaltens (130) und/oder eine Frequenz des periodischen Umschaltens (130) von der Kapazität des wiederaufladbaren elektrischen Energiespeichers (400) unabhängig ist.

8. Verfahren (10) nach einem der Ansprüche 1 bis 7, wobei der wiederaufladbare elektrische Energiespeicher (400) elektrochemische Zellen umfasst, und/oder wobei eine Nennspannung oder Leerlaufspannung (220) des wiederaufladbaren elektrischen Energiespeichers (400) im Bereich von 12 V bis 48 V ist, und/oder wobei eine Kapazität des wiederaufladbaren elektrischen Energiespeichers (400) im Bereich von 1 Ah bis 100 Ah ist.

9. Verfahren (10) nach einem der Ansprüche 1 bis 8, wobei der wiederaufladbare elektrische Energiespeicher (400) zur Entnahme der ersten Stromstärke (212) über einen ersten Widerstand (480) entladen wird und zur Entnahme der zweiten Stromstärke (214) über einen zweiten Widerstand (490) oder über eine Parallelschaltung des ersten Widerstands (480) und eines zweiten Widerstands (490) entladen wird, und/oder

   wobei Messwerte von Widerständen (480, 490) einer Messeinrichtung, auf denen die erste Stromstärke (212) und die zweite Stromstärke (214) basieren, in der Messeinrichtung hinterlegt sind, und/oder wobei die Messwerte der Widerstände (480, 490) der Messeinrichtung mindestens zehnfach größer als der Innenwiderstand sind.

10. Verfahren (10) nach Anspruch 9, wobei beim periodischen Umschalten (130) zwischen der ersten und zweiten Stromstärke (212, 214) mittels eines Feldeffekttransistors zwischen dem ersten und zweiten Widerstand (480, 490) umgeschaltet wird oder mittels eines Feldeffekttransistors der zweite Widerstand (490) parallel zum ersten Widerstand (480) zugeschaltet wird,

    optional wobei eine Frequenz des periodischen Umschaltens größer als oder gleich 100 Hz ist.

**11.** Verfahren (10) nach Anspruch 10, wobei die Messwerte um den Widerstand von elektrisch leitenden Verbindungselementen zwischen dem elektrischen Energiespeicher (400) und der Messeinrichtung korrigiert werden.

**12.** Verfahren (10) nach einem der Ansprüche 1 bis 11, wobei die erste Stromstärke (212) und die zweite Stromstärke (214) durch eine Regelung konstant gehalten werden.

**13.** Verfahren (10) nach einem der Ansprüche 1 bis 12, wobei die erste Stromstärke (212) und die zweite Stromstärke (214) ein Verhältnis von 1 zu 2 aufweisen.

**14.** Steuerung (50) zur Ermittlung eines Innenwiderstandes eines wiederaufladbaren elektrischen Energiespeichers (400), wobei die Steuerung (50) dazu ausgebildet ist, die Schritte eines der Ansprüche 1 bis 13 auszuführen.

**15.** Unterbrechungsfreie Stromversorgung (60), welche einen wiederaufladbaren elektrischen Energiespeicher (400) umfasst oder damit elektrisch leitend verbindbar ist, und welche die Steuerung (50) zur Ermittlung eines Innenwiderstandes des wiederaufladbaren elektrischen Energiespeichers (400) nach Anspruch 14 umfasst.

Fig. 1

200

Fig. 2

Fig. 3

Fig. 4

Fig. 5

60

610

610

50

400

620    620

Fig. 6

Europäisches Patentamt
European Patent Office
Office européen des brevets

# EUROPÄISCHER RECHERCHENBERICHT

**Nummer der Anmeldung**

**EP 23 16 9276**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 632 782 A1 (DELPHI TECH INC [US]) 8. März 2006 (2006-03-08)<br><br>* Zusammenfassung; Anspruch 1 *<br>* Absätze [0001], [0017], [0027] – [0031]; Abbildungen 1-4 *<br>* Absätze [0033] – [0037]; Abbildungen 6, 7 * | 1-4, 6-11,13, 14 | INV.<br>G01R31/389<br>B60L58/16<br>H01M10/48<br>H02J9/06 |
| X | US 2021/033677 A1 (CHENG WIN SHENG [US]) 4. Februar 2021 (2021-02-04)<br>* Zusammenfassung; Ansprüche 1, 2 *<br>* Absätze [0001] – [0016] *<br>* Absätze [0028] – [0042]; Abbildungen 1, 2 * | 1,5,11, 12,14,15 | |
| X | US 2019/271745 A1 (SUN LINYU [JP]) 5. September 2019 (2019-09-05)<br>* Zusammenfassung *<br>* Absätze [0027] – [0051]; Abbildungen 1-8 * | 1,5,11, 14,15 | |

**RECHERCHIERTE SACHGEBIETE (IPC)**

B60L
H01M
H02J
G01R

Der vorliegende Recherchenbericht wurde für alle Patentansprüche erstellt

| Recherchenort | Abschlußdatum der Recherche | Prüfer |
|---|---|---|
| München | 3. Mai 2023 | Burkart, Johannes |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 23 16 9276

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-05-2023

| Im Recherchenbericht angeführtes Patentdokument | Datum der Veröffentlichung | Mitglied(er) der Patentfamilie | Datum der Veröffentlichung |
|---|---|---|---|
| EP 1632782 A1 | 08-03-2006 | KEINE | |
| US 2021033677 A1 | 04-02-2021 | KEINE | |
| US 2019271745 A1 | 05-09-2019 | CN 110217108 A | 10-09-2019 |
| | | DE 102019105146 B3 | 04-07-2019 |
| | | JP 7069837 B2 | 18-05-2022 |
| | | JP 2019152527 A | 12-09-2019 |
| | | US 2019271745 A1 | 05-09-2019 |
| | | US 2021190872 A1 | 24-06-2021 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- How to Measure Internal Resistance. Battery University